## Europäisches Patentamt
## European Patent Office
## Office européen des brevets

(11) Veröffentlichungsnummer: **0 003 231**
**B1**

(12) **EUROPÄISCHE PATENTSCHRIFT**

(45) Veröffentlichungstag der Patentschrift: **14.10.81**

(21) Anmeldenummer: **78101752.0**

(22) Anmeldetag: **18.12.78**

(51) Int. Cl.³: **H 01 L 29/78,**
**H 01 L 21/265**

(54) **MIS-Feldeffekttransistor mit kurzer Kanallänge und Verfahren zu dessen Herstellung.**

(30) Priorität: **23.01.78 DE 2802838**

(43) Veröffentlichungstag der Anmeldung:
**08.08.79 Patentblatt 79/16**

(45) Bekanntmachung des Hinweises auf die Patenterteilung:
**14.10.81 Patentblatt 81/41**

(84) Benannte Vertragsstaaten:
**BE FR GB NL**

(56) Entgegenhaltungen:
**TECHNICAL DIGEST, 1977, International
Electron Devices Meeting, Dezember 5—7, 1977,
Washington D.C.,**

**J. TIHANYI et al. "Dimos — a novel IC technology
with submicron effective channel Msfets", Seiten
399—401**

(73) Patentinhaber: **SIEMENS AKTIENGESELLSCHAFT
Berlin und München
Postfach 22 02 61
D-8000 München 22 (DE)**

(72) Erfinder: **Pfleiderer, Hans-Jörg
Franz-Krinning-Weg 23
D-8011 Zorneding (DE)**
Erfinder: **Widmann, Dietrich
Johann-Strauss-Strasse 6
D-8025 Unterhaching (DE)**

Courier Press, Leamington Spa, England.

# 0 003 231

MIS-Feldeffekttransistor mit kurzer Kanallänge und Verfahren zu dessen Herstellung

Die Erfindung betrifft einen MIS-Feldeffekttransistor mit kurzer Kanallänge, enthaltend einen Halbleiterkörper, eine die Halbleiteroberfläche bedeckende Isolierschicht, eine Drain-Elektrode und eine Source-Elektrode je in Kontakt mit der Halbleiteroberfläche und eine auf der Isolierschicht zwischen den Elektroden befindliche Gate-Elektrodenschicht, wobei sich von den Kontaktflächen der Elektroden aus jeweils ein Drain-Gebiet und Source-Gebiet von einem ersten Leitungstyp in den Halbleiterkörper erstreckt und das Source-Gbiet wenigstens in Richtung auf das Drain-Gebiet hin von einem weiteren, unterhalb der Gate-Elektrode an die Halbleiteroberfläche angrenzenden Gebeit von einem zweiten Leitungstyp umschlossen ist, wobei sich zwischen dem Source-Gebiet und dem weiteren Gebiet ein zweites, weniger stark dotiertes Gebiet vom ersten Leitungtyp erstreckt und das Drain-Gebiet von einem weniger stark dotierten, das Drain-Gebiet in Richtung auf das Source-Gebiet umschließenden Gebiet vom ersten Leitungstyp umgeben ist, und wobei die Dotierung vom zweiten Leitungstyp durch Implantation gebildet ist.

"Aus dem Dokument Technical Digest, 1977, International Electron Devices Meeting, Dezember 5—7, 1977, Washington, Seiten 399—401 sind über den vorstehenden 1. Teil des Anspruchs 1 hinaus auch die Merkmale der Ansprüche 2,3 und 5 bekannt. Ferner ist es aus diesem Dokument bekannt, daß bei einem Verfahren zur Herstellung eines MIS-Feldeffekttransistors mit kurzer Kanallänge ein an seiner Oberfläche von einer Isolierschicht bedeckter, mit einer Source-Elektrode und einer Drain-Elektrode zu kontaktierender Halbleiterkörper mit einer über der Isolierschicht zwischen diesen Elektroden anzubringenden Gate-Elektrodenschicht und je einem von der Kontaktfläche der Elektroden aus sich in den Halbleiterkörper erstreckenden Source-Gebiet und Drain-Gebiet von einem ersten Leitungstyp hergestellt wird, wobei vor dem Aufbringen der Elektroden und nach dem Aufbringen der Gate-Elektrodenschicht Dotierteilchen in den Halbleiterkörper implantiert werden, wobei als Implantationsmaske eine auf der Halbleiteroberfläche befindliche Schicht verwendet wird, die auf der für die Gate-Elektrodenschicht vorgesehenen Fläche dicker als an den Rändern ist und deren Ränder das Source-Gebiet und das Drain-Gebiet überlappen und dort keilförmig abfallen und wobei bei abgedecktem Drain-Gebiet unter Verwendung der Implantationsmaske Dotierstoffteilchen vom zweiten Leitungstyp so implantiert werden, daß das weitere Gebiet unter den keilförmigen Rändern der Implantationsmaske schräg an die Halbleiteroberfläche heranreicht, und wobei als Implantationsmaske eine Doppelschicht aus einer Isolierschicht und der darüberliegenden Gate-Elektrodenschicht verwendet wird, wobei die Gate-Elektrodenschicht als eine Schicht aus Polykristallinemsilicium mit keilförmig zu dem Source-Gebiet und dem Drain-Gebiet abfallenden Rand hergestellt wird."

Beispielsweise aus dem gleichen Dokument ist ein MIS-Feldeffekttransistor mit kurzer Kanallänge bekannt, der einen Halbleiterkörper, eine die Halbleiteroberfläche bedeckende Isolierschicht, eine Drain-Elektrode und eine Source-Elektrode, jeweils in Kontakt mit der Halbleiteroberfläche, und eine die Isolierschicht zwischen den Elektroden bedekkende Gate-Elektrodenschicht enthält. Von den Kontaktflächen der Elektroden aus erstrecktsich jeweils ein Drain-Gebiet und Source-Gebiet von einem ersten Leitungstyp in den Halbleiterkörper. Das Source-Gebiet wird dabei wenigstens in Richtung auf das Drain-Gebiet hin von einem weiteren unterhalb der Gate-Elektrode an die Halbleiteroberfläche angrenzenden Gebiet vom zweiten Leitungstyp umschlossen.

Ein derartiger MIS-Feldeffekttransistor wird als "doppeldiffundierter MIS-FET" bezeichnet und besitzt eine kurze Kanallänge. Zur Herstellung des kurzen Kanals wird Dotierstoff eines bestimmten Leitungstyps durch eine Maskenöffnung in den Halbleiterkörper hineindiffundiert. Dabei gelangt das Dotiermaterial in dem Halbleiterkörper durch Unterdiffusion auch seitlich über die Grenzen der Maskenöffnung hinaus. Danach wird das eigentliche Source-Gebiet hergestellt, indem mit einem zweiten Dotierungsschritt Dotiermaterial des anderen Leitungstyps durch die gleiche Maskenöffnung eindiffundiert. Durch Wahl der Diffusionstemperatur und der Diffusionszeit wird bei diesem zweiten Dotierungsschritt dafür gesorgt, daß die seitliche Diffusion unter dem Rand der Maske geringer ist als beim ersten Dotierungsschritt. Die beiden dotierten Gebiete grenzen an verschiedenen Orten der Substratoberfläche an. Der zwischen diesen Orten befindliche Teil des Halbleitersubstrates, im wesentlichen also die Breite, um welche die erste Dotierung tiefer in den Halbleiter getrieben wurde als bei der Source-Dotierung, stellt den Kanal dar, über dem die Gate-Elektrode angeordnet wird. Mit diesem Verfahren können Kanallängen bis herab zu etwa 1,5 $\mu$m, erreicht werden.

Noch kürzere Kanallängen lassen sich mit diesem Doppeldiffusionsverfahren nicht mit hinreichender Reproduzierbarkeit erzielen, da beim Eintreiben von Dotierstoff mittels Diffusion das Dotierungsprofil zunehmend aufweitet, so daß aus deiesem Grunde bereits eine untere Grenze für die erreichbare Kanallänge gegeben ist. Weiterhin ist die Diffusion stark temperaturabhängig, so daß sich bereits kleine Temperaturänderungen nachteilig auf die Reproduzierbarkeit dieses Verfahrens auswirken.

Ferner ist es für viele Anwendungszwecke nachteilig, daß die Durchbruchsspannung bei einem MIS-FET verhältnismäßig niedrig ist. Bei einem Standard-p-Kanal-MOS-FET liegt diese Durchbruchsspannung bei −30 V, was durch den "field crowding"-Effekt bedingt ist, da das elektrische Feld im Drain-Gebiet nahe der Gate-Elektrode bei Überschreitung der Durchbruchsspannung höher wird als das Feld im Halbleiterkörper selbst (K. Tokuyama et al in "Mikroelektronik", 1976, Seiten 177 bis 181).

2

# 0 003 231

Kürzere, auch unterhalb von 1 $\mu$m liegende Kanallängen werden bei einem MIS-Feldeffekttransistor der eingangs genannten Art erreicht.

Aufgabe der Erfindung ist es, einen MIS-Feldeffekttransistor anzugeben, dessen Kanalläge noch weiter herabgesetzt ist, z. B. auf 0,1 $\mu$m oder darunter. Dadurch läßt sich die Schaltgeschwindigkeit bzw. das Hochfrequenzverhalten des Transistors verbessern. Ferner wird mit der Erfindung auch eine Erhöhung der Durchbruchsspannung des MIS-FET angestrebt.

Gemäß der Erfindung wird das bei einem MIS-Feldeffekttransistor der eingangs genannten Art dadurch erreicht, daß der Konzentrationsverlauf in dem durch Implantation gebildeten weniger stark dotierten Gebiet vom ersten Leitungstyp ein Maximum aufweist, das zwischen der Begrenzung des Source-Gebietes und dem Konzentrationsmaximum der Ladungsträger vom zweiten Leitungstyp in dem weiteren Gebiet liegt, und den Anstieg der Ladungsträgerkonzentration vom zweiten Leitungstyp in dem weiteren Gebiet derart kompensiert, daß an der Grenze zwischen dem weniger stark dotierten Gebiet und dem weiteren Gebiet im Halbleiterkörper ein steller Übergang von ersten zum zweiten Leitungstyp auftritt.

In unserer eigenen, nicht vorveröffentlichten deutschen Patentanmeldung P 27 03 877.3 (eigenes Aktenzeichen VPA 77 P 7007) ist bereits ein MIS-FET mit kurzer Kanallänge entsprechend dem ersten Teil des Anspruchs 1 vorgeschlagen, bei dem sowohl das Source-Gebiet wie das weitere, das Source-Gebiet umschließende Gebiet vom zweiten Leitungstyp durch Implantation erzeugt wird. Die Kanallänge wird dabei im wesentlichen von der Breite des weiteren Gebietes vom zweiten Ladungstyp bestimmt. Diese Breite kann durch die Implantation wesentlich genauer eingestellt werden als durch Diffusion wie bei dem bekannten doppelt-diffundierten MIS-FET. Jedoch nimmt dabei die Konzentration der implantierten Ladungsträger vom zweiten Leitungstyp in diesem weiteren Gebiet zunächst allmählich zu, um beim Erreichen des Konzentrationsmaximums mit zunehmendem Abstand von der Source-Elektrode rasch abzufallen. Eine weitere Verkürzung der Kanallänge wird gemäß der Erfindung dadurch erreicht, daß in einem zusätzlichen Implantationsschritt Ladungssträger des ersten Leitungstyps implantiert werden, deren Konzentrationsmaximum zwischen der Begrenzung des Source-Gebietes und dem Konzentrationsmaximum der Ladungsträger vom zweiten Leitungstyp in dem weiteren Gebiet liegt, und deren Konzentration geringer ist als in dem Source-Gebiet. Dadurch wird der langsame Anstieg der Ladungsträger konzentration vom zweiten Leitungstyp teilweise kompensiert oder überkompensiert, so daß der Halbleiterkörper in der Umgebung des Source-Gebietes einen rascheren Übergang vom ersten Leitungstyp zum zweiten Leitungstyp aufweist, auf den dann der rasche Abfall der Ladungsträgerkonzentration vom zweiten Leitungstyp dem Konzentrationsmaximum folgt. Dadurch läßt sich die Kanallänge noch weiter herabsetzen, z. B. auf 0,1 $\mu$m, und zuverlässig und genau einstellen.

Zur Herstellung eines derartigen MIS-FET kann auf die übliche Technik zurückgegriffen werden, bei der ein an seiner Oberfläche von einer Isolierschicht bedeckter, mit einer Source-Elektrode und einer Drain-Elektrode zu kontaktierender Halbleiterkörper mit einer zwischen diesen Elektroden über der Isolierschicht anzubringenden Gate-Elektrodenschicht und je einem von den Kontaktflächen der Elektroden aus sich in den Halbleiterkörper erstreckenden Source-Gebiet und Drain-Gebiet von einem ersten Leitungstyp hergestellt wird. Im Unterschied zu bekannten Verfahren werden jedoch vor dem Aufbringen der Elektroden und vor oder nach dem Aufbringen der Gate-Elektrodenschicht weitere Implantierungen vorgenommen.

Hierzu wird als Implantationsmaske eine auf der Halbleiteroberfläche befindliche Schicht verwendet, die auf der für die Gate-Elektrodenschicht vorgesehenen Fläche dicker als an den Rändern ist und deren Ränder das Source-Gebiet und das Drain-Gebiet überlappen und dort keilförmig abfallen. Vorteilhaft kann als abdeckendes Maskenteil die für die Schaltung ohnehin erforderliche Isolierschicht oder die Doppelschicht aus Isolierschicht und Gate-Elektrodenschicht verwendet werden, sofern diese Schichten über den für die Source- und Drain-Gebiete vorgesehenen Teilen der Halbleiteroberfläche Fenster aufweisen, deren Ränder zu diesen Gebieten hin keilförmig abfallen. Die Halbleiteroberfläche kann dabei in den Fenstern über diesen Gebieten von einer im Vergleich zu dem restlichen Teil der Isolierschicht dünneren Isolierschicht überdeckt sein, sie kann aber auch ganz freigelegt sein. Wesentlich hierbei ist nur, daß bei der nachfolgenden Implantation die Implantationsteilchen in den Fenstern höchstens eine dünne Oberflächenschicht zu durchdringen haben, bevor sie in den Halbleiterkörper in dem für das Source-Gebiet und das Drain-Gebiet vorgesehenen Bereich eindringen können, während außerhalb dieser Gebiete die Implantationsmaske so dick ist, daß sie von den Implantationsteilchen nicht durchdrungen werden kann.

Die keilförmigen Ränder der Implantationsmaske, gegebenenfalls also der Isolierschicht und/oder der Gate-Elektrodenschicht, können mittels geeigneter Verfahren erzeugt werden, wie sie z.B. in der deutschen Offenlegungsschrift 25 54 638 oder der deutschen Patentanmeldung P 27 23 933 beschrieben sind.

Bei der anschließenden Implantierung von Dotierteilchen des ersten Ladungstyps wird die Beschleunigungsenergie nun derart gewählt, daß die Dotierteilchen in den Maskenöffnungen tiefer in den Halbleiterkörper eindringen als der Tiefe des Source-Gebietes entspricht. Unterhalb der abgeschrägten Kanten der Maske dringen die Teilchen nach Durchlaufen der Maskenränder weniger tief in den Halbleiterkörper ein, do daß ein Konzentrationsprofil entsteht, bei dem das Maximum der Konzen-

3

tration stets unterhalb dem Source-Gebiet liegt, jedoch entsprechend dem keilwinkel der Maskenränder schräg bis an die Halbleiteroberfläche heranreicht. Die Implantationsdichte wird dabei so gewählt, daß das dadurch erzeugte Gebiet schwächer dotiert ist, als das Source-Gebiet selbst. Auf die gleiche Weise wird auch das Drain-Gebiet von einem schwächer dotierten Gebiet umgeben.

Anschließend wird die Implantation mit den Dotierteilchen des zweiten Leitungstyps vorgenommen, wobei die Implantationsenergie derart gewählt wird, daß das Konzentrationsmaximum der Dotierteilchen bei dieser zweiten Implantation unter dem in der ersten Implantationsstufe erzeugten Konzentrationsmaximum verläuft. Auch das dadurch erzeugte Gebiet vom zweiten Ladungstyp reicht unter den keilförmigen Rändern der Implantationssmaske (d.h. der Gate-Elektrodenschicht oder der für die Gate-Elektrodenschicht vorgesehenen Fläche) schräg an die Halbleiteroberfläche heran.

Die Reihenfolge der Implantationsschritte kann dabei auch vertauscht werden.

Vorteilhaft besteht der Halbleiterkörper aus Silizium mit einer p-Dotierung von $10^{13}$ bis $10^{14}$ $cm^{-3}$. Die Halbleiteroberfläche ist von einer $SiO_2$-Schicht bedeckt, deren Dicke über dem Gage-Gebiet und dem Drain-Gebiet vorteilhaft weniger als 0,2 $\mu$m, insbesondere etwa 0,06 $\mu$m beträgt. Das Source-Gebiet und das Drain-Gebiet weist vorteilhaft eine n-Dotierung von etwa $10^{19}$ $cm^{-3}$ oder mehr auf, die ebenfalls unter Verwendung der für die spätere Implantationen vorgesehenen Implantationsmasken durch Diffusion oder durch Implantation erzeugt werden kann. Dabei kann vorteilhaft Phosphor mit einer Beschleunigungsenergie von 20 bis 50 keV oder Arsen mit einer Beschleunigung von 100 bis 200 keV verwendet werden.

Die weniger stark dotierten Gebiete des ersten. Leitungstyps werden bevorzugt durch Implantation mit Phosphor bei Beschleunigungsenergien von etwa 80 bis 300 keV und einer Dosis von 1 bis $4 \cdot 10^{12}$ $cm^{-2}$ implantiert werden. Das weitere Gebiet wird bevorzugt durch Implantation von Bor mit einer Beschleunigungsenergie zwischen etwa 100 bis 300 keV und einer Dosis von 1 bis $4 \cdot 10^{12}$ $cm^{-2}$ erzeugt.

Das Wesen der Erfindung und weitere vorteilhafte Merkmale werden anhand zweier Ausführungsbeispiele und 6 Figuren noch näher erläutert.

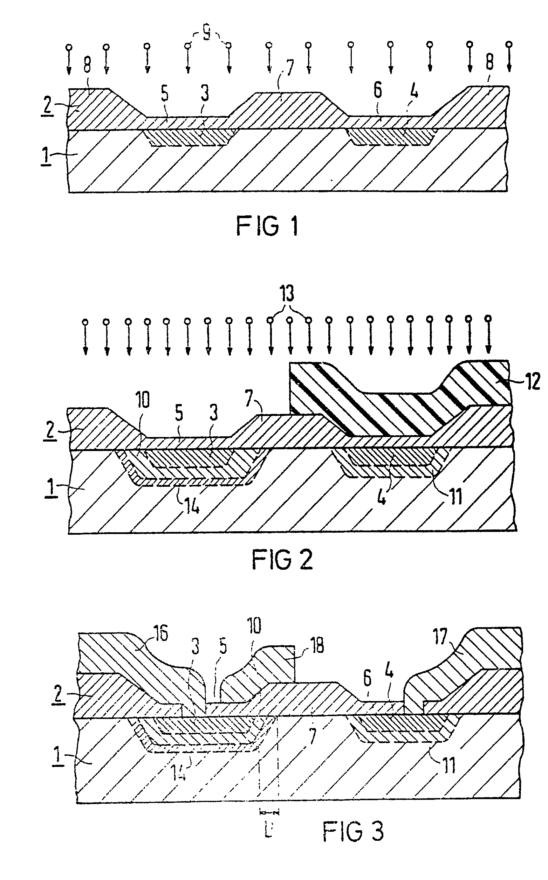

Bei der Herstellung eines MIS-Feldeffekttransistors nach den Fig. 1 bis 3 gemäß der Erfindung wird auf einen schwach mit Bor dotierten (Dotierung $7 \cdot 10^{14}$ $cm^{-3}$) Halbleiterkörper 1, der vorteilhaft aus Silizium besteht, eine Isolierschicht 2, bevorzugt aus $SiO_2$, aufgebracht, die über den für den Source-Bereich 3 und den Drain-Bereich 4 vorgesehenen Bereichen eine geringere Dicke von etwa 0,06 $\mu$m (Schichten 5 und 6) besitzt, jedoch zwischen diesen Bereichen und um den für den Transistor benötigten Teil der Halbleiteroberfläche eine Dicke von etwa 0,6 $\mu$m aufweist (Schichten 7 und 8). Die Kanten der dicken Schichten 7 und 8 fallen zu den dünneren Schichten 5 und 6 hin keilförmig ab. Ein reproduzierbarer Keilwinkel, vorzugsweise zwischen 15° und 60°, insbesondere etwa 20°, kann dabei auf verschiedene Weise erreicht werden.

Dazu kann zunächst von einer einheitlich dicken Isolierschicht von etwa 0,6 $\mu$m ausgegangen werden, die über den Gebieten 5 und 6 mittels eines Ionenätzverfahrens abgetragen wird, bei dem unter Zuhilfenahme einer Maske die Isolierschicht durch Ionenbeschuß abgesputtert wird. Dabei wird eine Ätzmaske mit entsprechenden Fenstern auf die Isolierschicht aufgebracht. Als Material für die Mask kann ein Stoff verwendet werden, der beim Absputtern selbst abgetragen wird. Dabei werden die Ränder der Maske im Bereich der Fenster abgeschrägt und dieses Profil der Ätzmaske in die abzuätzende Isolierschicht übertragen. Die Ränder der dicken Isolierschicht werden dann nicht von senkrecht zur Oberfläche des Halbleitersubstrats verlaufenden Flächen begrenzt, sondern von Flächen, die einen Keilwinkel bis zu etwa 60° aufweisen. Als Ätzmaske ist für ein solches Verfahren eine Maske aus Fotolack geeignet.

Man kann ein keilartiges Profil aber auch dadurch erreichen, daß als Isolierschicht eine $SiO_2$-Schicht mit einer darüberliegenden Phosphorglasschicht verwendet wird. Wird in eine solche Doppelschicht mit Fluorwasserstoffsäure eine Öffnung oder Vertiefung eingeätzt, so erhält man schräg ansteigende Begrenzungsflanken der Öffnung bzw. Vertiefung, da die Phosphorglasschicht von dem Ätzmittel stärker angegriffen wird als die darunterliegende $SiO_2$-Schicht. Nach dem Ätzen kann die Phosphorglasschicht durch Anschmelzen noch verrundet werden.

Eine weitere Möglichkeit besteht darin, die Isolierschicht 2 ganzflächig mit Ionen zu beschießen und anschließend mittels einer Ätzmaske eine naßchemische Ätzung oder Plasmaätzung durchzuführen. Die von dem Ionenstrahl gestörte dünne Oberflächenschicht der Isolierschicht weist dabei eine höhere Abtragung beim naßchemischen Ätzen oder beim Plasmaätzen auf als die dem Ionenstrahl nicht ausgesetzten tieferen Bereiche der Isolierschicht. Infolgedessen wird die Isolierschicht von den Fenstern der Maske aus mit unterschiedlichen Ätzraten abgetragen und man erhält eine von den Fenstern aus keilartig zu den unter der Maske liegenden Bereiche ansteigende Isolierschicht.

Derartige Methoden liefern gut reproduzerbare keilartig ansteigende Profile. Man kann dabei die Isolierschicht im Bereich der Drain- und Source-Gebiete bis auf die Halbleiteroberfläche abätzen und die dünnen Isolierschichten 5 und 6 anschließend z.B. mittels Aufwachsen aufbringen, man kann aber auch die dicke Isolierschicht bis zu der gewünschten Dicke der dünneren Schichten 5 und 6 abätzen.

Die erhaltene Isolierschicht wird nun als Implantationsmaske für die Herstellung der dotierten Bereiche im Halbleiterkörper verwendet. Hierzu kann z.B. Arsen mit einer Beschleunigungsspannung von etwa 150 keV oder Phosphor mit einer Beschleunigungsspannung von etwa 40 keV implantiert

4

# 0 003 231

werden, wobei die Dotierstoffteilchen etwa 70 nm tief in den Halbleiterkörper eindringen. Die Geometrie der auf diese Weise erzeugten Gebiete 3 und 4 für Source und Drain ist dabei durch das Profil der Isolierschicht bestimmt, wobei die Begrenzung unterhalb der keilförmigen Ränder der Isolierschicht ebenfalls schräg an die Oberfläche heranreicht. Die Dotierung dieses Gebietes beträgt etwa $10^{19}$ cm$^{-3}$.

Anschließend wird in einem zweiten Implanatationsschritt (Pfeile 9) Phosphor mit einer Beschleunigungsspannung von etwa 150 keV und einer Dosis von etwa 1 bis $4 \cdot 10^{12}$ cm$^{-2}$ eingebracht. Das Konzentrationsmaximum dieser Dotierteilchen liegt dabei bei etwa 100 nm. Dadurch werden schwächer n-dotierte Gebiete 10 und 11 erzeugt, die unterhalb des Source-bzw. Drain-Gebietes verlaufen und unter den keilförmigen Rändern der Isolierschicht 7 schräg an die Substratoberfläche heranreicht.

Anschließend wird nun das Drain-Gebiet 6 mittels einer Fotolack-Maske 12 abgedeckt und entsprechend der Pfeile 13 Bor miteiner Beschleunigungsspannung von etwa 150 keV und einer Dosis von etwa 1 bis $4 \cdot 10^{12}$ cm$^{-2}$ bestrahlt. Die Eindringtiefe dieser Dotierteilchen beträgt dabei etwa 400 nm. Es entsteht dadurch ein weiteres (p-dotiertes) Gebiet 14, das das n$^+$-dotierte Source-Gebiet 3 und das zweite n-dotierte Gebiet 10 umschließt und unter den keilartigen Rändern der Isolierschicht ebenfalls schräg an die Halbleiteroberfläche heranreicht.

Nach dieser Dotierung wird die Fotolackmaske 12 entfernt und es werden zur Herstellung von Elektrodenkontakten Kontaktlöcher in die Teilschichten 5 und 6 der Isolierschicht eingeätzt. Danach werden Kontaktleiterbahnen 16 bzw. 17 zu dem Source-Gebiet 3 bzw. dem Drain-Gebiet 4 angebracht und es wird eine Gate-Elektrode 18 auf der Isolierschicht 7 abgeschieden, die den Rand des p-dotierten Bereiches 14 überlappt. Fig. 3 gibt die endgültige Struktur des MIS-FET wieder.

Der wirksame Kanalbereich L ist dabei durch die Breite des Gebietes 14 an der von der Gate-Elektrode überlappten Halbleiteroberfläche gegeben. Durch die selbstjustierende Implantation der Dotierstoffe unter Verwendung einer einzigen Maske ist es dabei möglich, die Kanallänge L genau einzustellen. Die differenzierte Implantation liefert dabei einen raschen Übergang vom n- zum p-leitenden Material auf dem Weg vom Source-Gebiet, wodurch eine besonders geringe Kanalbreite erreicht werden kann. Derartige Transistoren besitzen daher eine große Steilheit und kurze Einschaltzeiten. Durch die zusätzliche n-Dotierung am Drain-Gebiet wird ferner gleichzeitig eine hohe Durchbruchsspannung erzeugt.

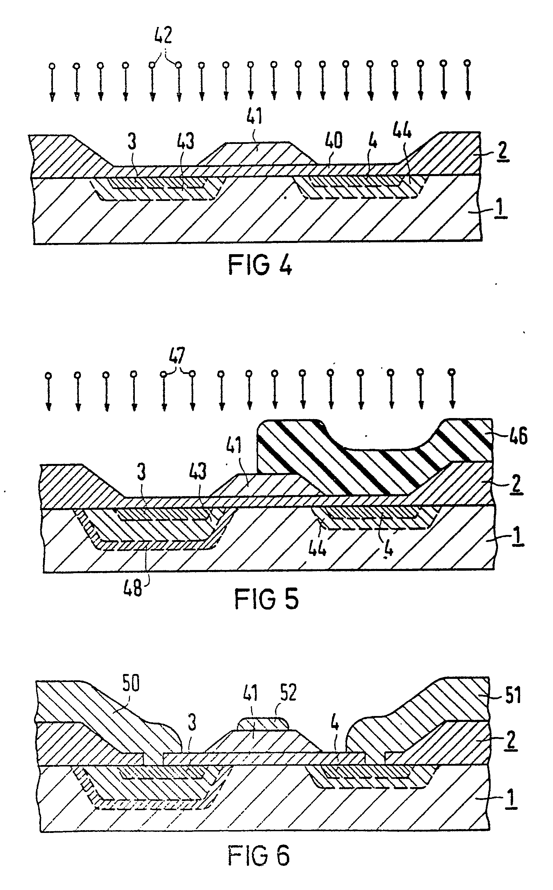

Bei dem Feldeffekttransistor nach den Fig. 4 bis 6 wird zur Herstellung von einem Halbleiterkörper 1 ausgegangen, der zumindest in dem Bereich, der später unter der Gate-Elektrodenschicht zu liegen kommt, eine verhältnismäßig schwache p-Dotierung, z.B. $7 \cdot 10^{14}$ cm$^{-3}$, aufweist. Die Oberfläche dieses Halbleiterkörpers 1 wird mit einer etwa 0,6 $\mu$m dicken SiO$_2$-Schicht 2 bedeckt, in dem ein Fenster mit schrägen Kanten ausgeätzt ist, das sich vom Source-Gebiet 3 bis zum Drain-Gebiet 4 erstreckt und in dem eine 0,06 $\mu$m dicke Gate-Oxidschicht 40 aufgebracht ist. Darüber wird eine Polysiliziumschicht, eventuell mit starker n-Dotierung, mit einer Dicke von 0,1 bis 0,5 $\mu$m abgeschieden. Aus dieser Polysiliziumschicht wird die Elektrodenschicht 41 geätzt, deren Kanten z.B. durch Absputtern abgeschrägt sind. Diese Doppelschicht aus Isolierschicht und Gate-Elektrodenschicht kann wiederum als Implantationsmaske benutzt werden.

Die n$^+$-Dotierung der Source- und Drain-Gebiete 3 und 4 kann, wie im vorangehenden Fall, durch Implantation erfolgen. Werden diese Gebiete durch Implantation nur belegt, so erfolgt anschließend eine Drive-in-Diffusion. In diesem Falle kann vorteilhaft das Polysilizium-Gate anschließend überätzt werden, um unter dem Polysilizium-Gate nahezu die ursprüngliche Substratdotierung zu haben. Die Dotierung von Source-Gebiet und Drain-Gebiet kann aber auch durch Diffusion erfolgen.

Anschließend werden ohne Verwendung weiterer Lackmaskierung wiederum Donatoren wie im oben angeführten Fall implántiert (Pfeile 42), wobei die Energie derart gewählt wird, daß unter der schrägen Polysilizium-Kante n-dotierte Profile 43 und 44 entsteht, die an die n$^+$-dotierten Source- und Gate-Gebiete 3 und 4 anschließen. Die Dosis dieser Implantation wird vorteilhaft so gewählt, daß die Donatorenkonzentration gleich der Akzeptorenkonzentration in dem für den Kanal vorgesehenen p-dotierten weiteren Gebiet entspricht. An der Drain-Seite wird durch dieses Verfahren eine hohe Durchbruchsspannung erzielt, da kein abrupter pn-Übergang mehr besteht.

Anschließend wird der Drain-Bereich mit einer Fotolackmaske 46 bedeckt und der Source-Bereich mit Akzeptoren implantiert (Pfeile 47). Die Implantationsenergie wird wiederum so gewählt, daß diese Ionen eine größere Eindrintiefe aufweisen als bei der vorangehenden n-Implantation, jedoch nicht in der Lage sind, den dicken Mittelteil der Doppelschicht aus Gate-Oxidschicht 40 und Gate-Elektrodenschicht 41 zu durchdringen. Daher wird der Verlauf der Donator- und Akzeptorkonzentration exakt vorgegeben und damit ein rascher, genau reproduzierbarer Übergang vom n-Leitungstyp (Gebiet 43) zum p-Leitungstyp (Gebiet 48) hervorgerufen, der durch die beiden Implantationsschritte vorgegeben ist. Der eigentliche Kanal ist dann bestimmt durch das p-leitende Gebiet 48, dessen Breite sehr klein gewählt werden kann und durch die Differenz der implantierten Dotierungen gegeben ist. Für diese Struktur wird daher die Bezeichnung "DIF-MOS" (differenziell implantierter MOS-Transistor) vorgeschlagen.

Abschließend wird die Fotolackmaske entfernt. Es werden Kontaktlöcher zu dem Source-Gebiet 3 und dem Drain-Gebiet 4 geätzt und entsprechende Elektroden 50 und 51 mit dazugehörigen Leiterbahnen sowie ein Anschluß 52 aus Metall zu der Polysilizium-Gate-Elektrodenschicht 41 angebracht. Die Gate-Elektrodenschicht wird dabei zweckmäßigerweise ganzflächig mit einer derartigen Zuleitung 52 versehen, wodurch der Leitungswiderstand verringert wird.

5

**0 003 231**

**Patentansprüche**

1. MIS-Feldeffekttransistor mit kurzer Kanallänge, enthaltend einen Halbleiterkörper (1), eine die Halbleiteroberfläche bedeckende Isolierschicht (2), eine Drain-Elektrode (16) und eine Source-Elektrode (17) je in Kontakt mit der Halbleiteroberfläche und eine auf der Isolierschicht (7) zwischen den Elektroden befindliche Gate-Elektrodenschicht (18), wobei sich von den Kontaktflächen der Elektroden aus jeweils ein Drain-Gebiet (4) und Source-Gebiet (3) von einem ersten Leitungstyp in den Halbleiterkörper erstreckt und das Source-Gebiet wenigstens in Richtung auf das Drain-Gebiet hin von einem weiteren, unterhalb der Gate-Elektrode an die Halbleiteroberfläche angrenzenden Gebiet von einem zweiten Leitungstyp umschlossen ist, wobei sich zwischen dem Source-Gebiet (3) und dem weiteren Gebiet (14) ein zweites, weniger stark dotiertes Gebiet (10) vom ersten Leitungstyp erstreckt, und das Drain-Gebiet (4) von einem weniger stark dotierten, das Drain-Gebiet in Richtung auf das Source-Gebiet umschließenden Gebiet (11) vom ersten Leitungstyp umgeben ist, und wobei die Dotierung vom zweiten Leitungstyp durch Implantation gebildet ist, dadurch gekennzeichnet, daß der Konzentrationsverlauf in dem durch Implantation gebildeten weniger stark dotierten Gebiet (10) vom ersten Leitungstyp ein Maximum aufweist, das zwischen der Begrenzung des Source-Gebietes (3) und dem Konzentrationsmaximum der Ladungsträger vom zweiten Leitungstyp in dem weiteren Gebiet (14) liegt, und den Anstieg der Ladungsträgerkonzentration vom zweiten Leitungstyp in dem weiteren Gebiet (14) derart kompensiert, daß an der Grenze zwischen dem weniger stark dotierten Gebiet (10) und dem weitern Gebiet (14) im Halbleiterkörper ein steiler Übergang vom ersten zum zweiten Leitungstyp auftritt.

2. MIS-Feldeffekttransistor nach Anspruch 1 dadurch gekennzeichnet, daß die Dicke der Gate-Elektrodenschicht (41) zum Source-Gebiet hin keilförmig abnimmt.

3. MIS-Feldeffekttransistor nach Anspruch 1 dadurch gekennzeichnet, daß die Dicke der Isolierschicht (7) zum Drain-Gebiet und zum Source-Gebiet hin keilförmig abnimmt.

4. MIS-Feldeffekttransistor nach Anspruch 2 oder 3, dadurch gekennzeichnet, daß der Keilwinkel zwischen 15° und 60°, insbesondere etwa 20°, beträgt.

5. MIS-Feldeffekttransistor nach einem der Ansprüche 1 bis 4, dadurch gekennzeichnet, daß der Halbleiterkörper (1) Silizium besteht.

6. MIS-Feldeffekttransistor nach Anspruch 5, dadurch gekennzeichnet, daß das Source-Gebiet (3) und das Drain-Gebiet (4) eine n-Dotierung, vorzugsweise mit Arsen oder Phosphor, von etwa $10^{19}$ cm$^{-3}$ oder mehr aufweisen.

7. MIS-Feldeffekttransistor nach Anspruch 6, dadurch gekennzeichnet, daß die schwächer dotierten Gebiete (10, 11) vom ersten Leitungstyp eine implantierte n-Dotierung, vorzugsweise mit Phosphor, von 1 bis 4 × $10^{12}$ cm$^{-2}$ aufweisen.

8. MIS-Feldeffekttransistor nach Anspruch 7, dadurch gekennzeichnet, daß das weitere Gebiet (14) vom zweiten Leitungstyp eine implantierte p-Dotierung, vorzugsweise mit Bor, von 1 bis 4 × $10^{12}$ cm$^{-2}$ aufweist.

9. MIS-Feldeffekttransistor nach einem der Ansprüche 1 bis 8, dadurch gekennzeichnet daß die Isolierschicht (2) aus $SiO_2$ besteht.

10. MIS-Feldeffekttransistor nach einem der Ansprüche 1 bis 9, dadurch gekennzeichnet daß die Gate-Elektrodenschicht aus polykristallinem Silizium besteht.

11. Verfahren zur Herstellung eines MIS-Feldeffekttransistors mit kurzer Kanallänge nach einem der Ansprüche 2 bis 10 dadurch gekennzeichnet, daß ein an seiner Oberfläche von einer Isolierschicht (2) bedeckter, mit einer Source-Elektrode (16) und einer Drain-Elektrode (17) zukontaktierender Halbleiterkörper (1) mit einer über der Isolierschicht (2) zwischen djesen Elektroden anzubringenden Gate-Elektrodenschicht (18) und je einem von der Kontaktfläche der Elektroden aus sich in den Halbleiterkörper erstreckenden Source-Gebiet (3) und Drain-Gebiet (4) von einem ersten Leitungstyp hergestellt wird, daß vor dem Aufbringen der Elektroden (16, 17) und vor oder nach dem Aufbringen der Gate-Elektrodenschicht (18) Dotierteilchen des ersten Leitungstyps (9) in den Halbleiterkörper implantiert werden, wobei als Implantationsmaske eine auf der Halbleiteroberfläche befindliche Schicht (2) verwendet wird, die auf der für die Gate-Elektrodenschicht vorgesehen Fläche dicker (7) als an den Rändern ist und deren Ränder das Source-Gebiet (3) und das Drain-Gebiet (4) überlappen und dort keilförmig abfallen, wobei ferner die Implantationsenergie und Implantationsdosis dieser Dotierstoffteilchen so gewählt wird, daß das Konzentrationsmaximum der Dotierteilchen des ersten Leitungstyps unterhalb des Source-Gebietes bzw. des Drain-Gebietes verläuft und unter den keilförmigen Rändern der Implantationsmaske schräg an die Substratoberfläche heranreicht und die dadurch entstehenden, das Source-Gebiet und Drain-Gebiet umgebenden Gebiete (10, 11) eine schwächere Dotierung als das Source-Gebiet und das Drain-Gebiet selbst aufweisen, und daß bei abgedecktem (12) Drain-Gebiet unter Verwendung der gleichen Implantationsmaske (2) Dotierstoffteilchen (13) vom zweiten Leitungstyp mit einer derartigen Implantationsenergie implantiert werden, daß das Konzentrationsmaximum der Dotierstoffteilchen des zweiten Leitungstyps unter dem Konzentrationsmaximum der Dotierstoffteilchen des ersten Leitungstyps verläuft und ebenfalls unter den keilförmigen Rändern der Implantationsmaske schräg an die Halbleiteroberfläche heranreicht.

12. Verfahren nach Anspruch 11, dadurch gekennzeichnet, daß die Implantationsmaske als eine $SiO_2$-Schicht und gegebenenfalls einer darüberliegenden Phosphorsilikat-Glasschicht hergestellt wird.

6

13. Verfahren nach Anspruch 11, dadurch gekennzeichnet, daß als Implantations maske eine Doppelschicht aus der Isolierschicht (2, 40) und der darüberliegenden Gate-Elektrodenschicht (41) verwendet wird, wobei die Isolierschicht über dem Source-Gebiet und dem Drain-Gebiet weniger als 0,2 $\mu$m dick ist und die Gate-Elektrodenschicht (41) als eine Schicht aus polykristallinem Silizium mit keilförmig zu dem Source-Gebiet und dem Drain-Gebiet abfallendem Rand hergestellt wird.

14. Verfahren nach einem der Ansprüche 11 bis 13, dadurch gekennzeichnet, daß das Source-Gebiet (3) und das Drain-Gebiet (4) unter Verwendung der zur Dotierung der anderen Gebiete vorgesehenen Implantationsmaske durch Implantation von Arsen mit einer Beschleunigung von etwa 100 bis 200 keV erzeugt wird.

15. Verfahren nach einem der Ansprüche 11 bis 13, dadurch gekennzeichnet, daß das Source-Gebiet (3) und das Drain-Gebiet (4) unter Verwendung der zur Erzeugung der weiteren Gebiete vorgesehenen Implantationsmasken durch Implantation von Phosphor mit 20 bis 50 keV erzeugt werden.

16. Verfahren nach einem der Ansprüche 11 bis 15, dadurch gekennzeichnet, daß die mit einem tiefer als das Source-Gebiet (3) bzw. das Drain-Gebiet (4) reichenden Konzentrationsmaximum zu implantierenden Teilchen des ersten Leitungstyps durch Implantation (9) mit Phosphor bei einer beschleunigungsenergie von 80 bis 300 keV implantiert werden.

17. Verfahren nach einem der Ansprüche 11 bis 16, dadurch gekennzeichnet, daß die Dotierstoffteilchen vom zweiten Leitungstyp durch Implantation (13) von Bor mit einer Beschleunigungsenergie von 100 bis 300 keV implantiert werden.

18. Verfahren nach einem der Ansprüche 11 bis 17, dadurch gekennzeichnet, daß als Halbleiterkörper (1) dotiertes Silizium mit einer Dotierung von $10^{13}$ bis $10^{14}$ cm$^{-3}$, vorzugsweise mit Bor, verwendet wird.

## Claims

1. An MIS field effect transistor of short channel length comprising a semiconductor body (1), an insulating layer (2) covering the semiconductor surface, a drain electrode (16) and a source electrode (17), each in contact with the semiconductor surface, and a gate electrode layer (18) arranged on the insulating layer (7) between the electrodes, wherein a drain zone (4) and source zone (3) of a first conductivity type each extend from the contact surfaces of the electrodes into the semiconductor body, wherein, at least in the direction towards the drain zone, the source zone is surrounded by a further zone of a second conductivity type which meets the semiconductor surface beneath the gate electrode, wherein a second less strongly doped zone (10) of the first conductivity type extends between the the source zone (3) and the further zone (14) wherein the drain zone (4) is surrounded by a less strongly doped zone (11) of the first conductivity type which surrounds the drain zone in the direction towards the source zone, and wherein the doping of the second conductivity type is produced by implantation, characterised in that the concentration curve in the less strongly doped zone (10) of the first conductivity type which is formed by implantation, exhibits a maximum which lies between the boundary of the source zone (3) and the concentration maximum of the charge carriers of the second conductivity type in the further zone (14), and which compensates the increase in charge carrier concentration of the second conductivity type in the further zone (14) in such a way that a steep transition from the first to the second conductivity type occurs at the boundary between the less strongly doped zone (10) and the further zone (14) in the semiconductor body.

2. An MIS field effect transistor as claimed in Claim 1, characterised in that the thickness of the gate electrode layer (41) falls to form a wedge shape towards the source zone.

3. An MIS field effect transistor as claimed in Claim 1, characterised in that the thickness of the insulating layer (7) falls to form a wedge shape towards the drain zone and towards the source zone.

4. An MIS field effect transistor as claimed in Claim 2 or 3, characterised in that the wedge angle is between 15° and 60°, in particular about 20°.

5. An MIS effect transistor as claimed in one of Claims 1 to 4, characterised in that the semiconductor body (1) consists of silicon.

6. An MIS field effect transistor as claimed in Claim 5, characterised in that the source zone (3) and the drain zone (4) exhibit an n-doping, preferably with arsenic or phosphorus, of about $10^{19}$ cm$^{-3}$.

7. An MIS field effect transistor as claimed in Claim 6, characterised in that the more weakly doped zones (10, 11) of the first conductivity type exhibit an implanted n-doping, preferably with phosphorus, of $1 - 4 \times 10^{12}$ cm$^{-3}$.

8. An MIS field effect transistor as claimed in Claim 7, characterised in that the further zone (14) of the second conductivity type exhibits an implanted p-doping, preferably with boron, of $1 - 4 \times 10^{12}$ cm$^{-2}$.

9. An MIS field effect transistor as claimed in one of Claims 1 to 8, characterised in that the insulating layer (2) consists of $SiO_2$.

10. An MIS field effect transistor as claimed in one of Claims 1 to 9, characterised in that the gate electrode layer consists of polycrystalline silicon.

11. A process for the production of an MIS field effect transistor of short channel length as claimed in one of Claims 2 to 10, characterised in that a semiconductor body (1) is produced which at its surface is covered by an insulating layer (2) and which has a source electrode (16) and a drain electrode (17) for contacting, and a gate electrode layer (18) which is applied above the insulating layer (2) between these electrodes, and with a source zone (3) and a drain zone (4) of a first conductivity type each of which extends from the contact surface of the electrode into the semiconductor body, that prior to the application of the electrodes (16, 17) and either before or after the application of the gate electrode layer (18), doping particles of the first conductivity type (9) are implanted into the semiconductor body using an implantation mask consisting of a layer (2) which is arranged on the semiconductor surface and which is thicker (7) at the area provided for the gate electrode layer than at the edges, and the edges of which overlap the source zone (3) and the drain zone (4) where they fall in a wedge shape; wherein, moreover, the implantation energy and implantation dose of thse doping particles are so selected that the concentration maximum of the doping particles of the fist conductivity type runs below the source zone and the drain zone, and extends obliquely to the substrate surface beneath the wedge-shaped edges of the implantation mask, and wherein the zones (10, 11) which are thus fomred and which surround the source zone and drain zone exhibit a weaker doping then the source and drain zones themselves; and that when the drain zone is covered (12) the same implantation mask (2) is used to implant doping particles (13) of the second conductivity type with an implantation energy which is such that the concentration maximum of the dopant particles of the second conductivity type runs below the concentration maximum of the dopant particles of the first conductivity type and likewise extends obliquely to the semiconductor surface beneath the wedge-shaped edges of the implantation mask.

12. A process as claimed in Claim 11, characterised in that the implantation mask is produced as an $SiO_2$-layer, and possibly an overlying phosphorus silicate glass layer.

13. A process as claimed in Claim 11, characterised in that a double layer consisting of the insulating layer (2, 40) and the overlying gate electrode layer (41) is used as implantation mask, where the insulating layer has a thickness of less than 0.2 $\mu$m above the source zone and the drain zone, and the gate electrode layer (41) is produced as a layer of polycrystalline silicon whose edge falls in a wedge shape towards the source zone and the drain zone.

14. A process as claimed in one of Claims 11 to 13, characterised in that the source zone (3) and the drain zone (4) are produced using the implantation mask provided for the doping of the other zones, by implanting arsenic at an acceleration of about 100 to 200 keV.

15. A process as claimed in one of Claims 11 to 13, characterised in that the source zone (3) and the drain zone (4) are produced, using the implantation masks provided for the production of the further zones, by implanting phosphorus at 20 to 50 keV.

16. A process as claimed in one of Claims 11 to 15, characterised in that the particles of the first conductivity type which are to be implanted with a concentration maximum which extends deeper than the source zone (3) or the drain zone (4), as the case may be, are implanted by implantation (9) using phosphorus at an acceleration energy of 80 to 300 keV.

17. A process as claimed in one of Claims 11 to 16, characerised in that the dopant particles of the second conductivity type are implanted by the implantation (13) of boron at an acceleration energy of 100 to 300 keV.

18. A process as claimed in one of Claims 11 to 17, characterised in that doped silicon with a doping of $10^{13}$ to $10^{14}$ $cm^{-3}$, preferably doped with boron, is used as the semiconductor body (1).

**Revendications**

1. Transistor à effet de champ à métal-isolateur-semiconducteur à canal de faible longueur, comportant un corps semiconducteur, une couche isolante recouvrant la surface du semiconducteur, une électrode de drain et une électrode de source dont chacune est en contact avec la surface du semiconducteur et une couche d'électrode de porte située sur la couche isolante, entre lesdites électrodes, du type dans lequel, à partir des surfaces de contact des électrodes, une région de drain et une région de source d'un premier type de conductibilité s'étendent dans le corps semiconducteur, alors que la région de source est entourée, au moins en direction de la région de drain, par une autre région jouxtant la surface du semiconducteur, en-dessous de l'électrode de porte, et possédant un second type de conductibilité, qu'entre la région de source et ladite autre région s'étend une seconde région moins dopée et possédant le premier type de conductibilité, que la région de drain est entourée par une région du premier type de conductibilité, moins dopée et entourant la région de drain en direction de la région de source et que le dopage du second type de conductibilité est réalisé par implantation, caractérisé par le fait que l'allure de la concentration présente, dans la région (10) du premier type de conductibilité, moins dopée et formée par implantation, un maximum qui se situe entre la limite entre la région de source (3) et la maximum de concentration des porteurs de charge du second type de conductibilité dans ladite autre région (14), et qui compense l'accroissement de la concentration en porteurs de charge du second type de conductibilité dans ladite autre région (14) de telle manière qu'à la limite entre la région moins fortement dopée (6) et ladite autre région (14) un passage abrupt apparaît dans le corps semiconducteur, entre le premier et le second type de conductibilité.

2. Transistor à effet de champ à métal-isolateur-semiconducteur selon la revendication 1, caractérisé par le fait que l'épaisseur de la couche d'électrode de porte (41) décroît en forme de biseau vers la région de source.

3. Transistor à effet de champ à métal-isolateur-semiconducteur selon la revendication 1, caractérisé par le fait que l'épaisseur de la couche isolante (7) décroît en forme de biseau en direction de la région de drain et la région de source.

4. Transistor à effet de champ à métal-isolateur-semiconducteur selon la revendication 2 ou 3, caractérisé par le fait que l'angle du biseau se situe entre 15 et 60°, et est plus particulièrement de l'ordre de 20°.

5. Transistor à effet de champ à métal-isolateur-semiconducteur selon l'une des revendications 1 à 4, caractérisé par le fait que le corps semiconducteur (1) est en silicum.

6. Transistor à effet de champ à métal-isolateur-semiconducteur selon la revendication 5, caractérisé par le fait que la région de source (3) et la région de drain (4) présentent un dopage en n, de préférence avec de l'arsenic ou du phosphore d'environ $10^{19}$ cm$^{-3}$ ou davantage.

7. Transistor à effet de champ à métal-isolateur-semiconducteur selon la revendication 6, caractérisé par le fait que les régions plus faiblement dopées (10, 11) du premier type de conductibilité présentent un dopage implanté du type n, de préférence avec du phosphore, de 1 à $4 \times 10^{12}$ cm$^{-2}$.

8. Transistor à effet de champ à métal-isolateur-semiconducteur selon la revendication 7, caractérisé par le fait que ladite autre région (14) du second type de conductibilité présente un dopage p implanté, de préférence avec du bore, de 1 à $4 \times 10^{12}$ cm$^2$.

9. Transistor à effet de champ à métal-isolateur-semiconducteur selon l'une des revendications 1 à 8, caractérisé par le fait que la couche isolante (2) est constituée avec du $SiO_2$.

10. Transistor à effet de champ à métal-isolateur-semiconducteur selon l'une des revendications 1 à 9, caractérisé par le fait que la couche d'électrodes de porte est constituée avec du silicium polycristallin.

11. Procédé pour la fabrication d'un transistor à effet de champ à métal-isolateur-semiconducteur et à courte longeur de canal, selon l'une des revendications 2 à 10, caractérisé par le fait qu'on prépare un corps semiconducteur (1) dont la surface est recouverte avec une couche isolante (2) et qui doit être contacté avec une électrode de source (16) et une électrode de drain (17), avec une couche d'électrode de porte (18) à disposer entre ces électrodes sur ladite couche isolante et une région de source (3) et une région de drain (4) d'un premier type de conductibilité et s'étendant respectivement à partir d'une surface de contact des électrodes dans ledit corps semiconducteur, qu'avant le dépôt des électrodes (16, 17) et avant ou après le dépôt de la couche d'électrode de porte (18), des particules de dopage du premier type de conductibilité (9) sont implantées dans le corps semiconducteur avec, comme masque d'implantation, une couche (2) située sur la surface du semiconducteur, dont l'épaisseur (7) est plus forte au niveau de la surface prévue pour la couche d'électrode de porte qu'au niveau des bords qui recouvrent partiellement la région de source (3) et la région de drain (4) pour s'y termioner en biseau, l'énergie de l'implantation et la dose d'implantation des particules de la substance de dopage étant choisies de manière que le maximum de concentration des particules du premier type de conductibilité passe sous la région de source ou de drain et atteint sous les bords biseautés du masque d'implantation obliquement la substance du substrat, les régions (10, 11) qui se forment ainsi et qui entourent les régions de source et de drain présentant un dopage plus faible que celui des régions de source et de drain, et qu'avec la région de drain recouverte (12) et avec mise en oeuvre du même masque d'implantation (2) des particules d'une substance dopante (13) du second type de conductibilite sont implantées avec l'énergie d'implantation telle que le maximum de concentration de ces particules de la substance de dopage du second type de conductibilité passe sous le maximum de concentration des particules de la substance de dopage du premier type de conductibilité et s'étend également sur les bords biseautés du masque d'implantation obliquement jusqu'à la surface du semiconducteur.

12. Procédé selon la revendication 11, caractérisé par le fait que le masque d'implantation est préparé sous la forme d'une couche en $SiO_2$ portant éventuellement une couche de verre au silicate de phosphore.

13. Procédé selon la revendication 11, caractérisé par le fait que l'on utilise comme masque d'implantation une double couche formée par une couche isolante (2, 40) et la couche d'électrode de porte (41) qui se trouve sur cette dernière, la couche isolante ayant, au-dessus de la région de source et de la région de drain, une épaisseur inférieure à 0,2 $\mu$m et la couche d'électrode de porte (41) étant réalisée sous la forme d'une couche de silicium polycristallin ayant des bords biseautés et inclinés sur la région de source et la région de drain.

14. Procédé selon l'un des revendications 11 à 13, caractérisé par le fait que la région de source (3) et la région de drain (4) sont réalisées, avec mise en oeuvre du masque d'implantation prévu pour le dopage des autres régions, par implantation d'arsenic avec une accélération d'environ 100 à 200 keV.

15. Procédé selon l'une des revendications 11 à 13, caractérisé par le fait que la région de source (3) et la région de drain (4) sont réalisées, avec mise en oeuvre des masques d'implantation prévus pour la préparation des autres régions, par implantation de phosphore avec 20 à 50 keV.

9

**0 003 231**

16. Procédé selon l'une des revendications 11 à 15, caractérisé par le fait que les particules du premier type de conductibilité à implanter avec un maximum de concentration s'étendant à une profondeur supérieur à celle de la région de source (3) ou de la région de drain (4), sont implantées avec du phosphore à une énergie d'accélération de 80 à 300 keV.

17. Procédé selon l'une des revendications 11 à 16, caractérisé par le fait que les particules de substance de dopage du second type de conductibilité sont implantées par implantation (13) de bore avec une énergie de'accélération de 100 à 300 keV.

18. Procédé selon l'une des revendications 11 à 17, caractérisé par le fait que l'on utilise comme corps semiconducteur (1) du silicium dopé avec un dopage de $10^{13}$ à $10^{14}$ $cm^{-3}$, de préférence avec du bore.

FIG 1

FIG 2

FIG 3

FIG 4

FIG 5

FIG 6